# EUROPEAN PATENT SPECIFICATION

(11) **EP 4 053 651 B1**
(45) Date of publication and mention of the grant of the patent: **01.05.2024**
(21) Application number: 22158400.6
(22) Date of filing: 24.02.2022
(51) Int. Cl.: G05B 13/02, G05B 13/04, G05B 17/02, G06N 20/00, G06N 3/00

(54) **DETERMINATION APPARATUS, DETERMINATION METHOD, AND DETERMINATION PROGRAM**
BESTIMMUNGSVORRICHTUNG, BESTIMMUNGSVERFAHREN UND BESTIMMUNGSPROGRAMM
APPAREIL DE DÉTERMINATION, PROCÉDÉ DE DÉTERMINATION, ET PROGRAMME DE DÉTERMINATION

(30) Priority: 03.03.2021 JP 2021033964
(43) Date of publication of application: 07.09.2022
(73) Proprietor: Yokogawa Electric Corporation, Musashino-shi, Tokyo 180-8750 (JP)
(72) Inventor: GOTOU, Hirotsugu, Musashino-shi, Tokyo 180-8750 (JP); KANOKOGI, Hiroaki, Musashino-shi, Tokyo 180-8750 (JP); FURUKAWA, Yota, Musashino-shi, Tokyo 180-8750 (JP); KOBUCHI, Keiichiro, Musashino-shi, Tokyo 180-8750 (JP); KAWAHARA, Mizuo, Musashino-shi, Tokyo 180-8750 (JP)
(74) Representative: Winter, Brandl - Partnerschaft mbB

(56) References cited:
- EP-A1- 3 719 592
- US-A1- 2019 004 518
- US-A1- 2020 192 340

## Description

### BACKGROUND

### 1. TECHNICAL FIELD

The present invention relates to a determination apparatus, a determination method, and a determination computer program.

### 2. RELATED ART

Japanese Patent Application Publication No. 2018-202564 discloses 'performs the machine learning of a compensation amount of a teaching position of a robot with respect to a disturbance produced in a motor that drives each joint of the robot, and compensates and controls the teaching position so as to reduce the disturbance when the robot moves to the teaching position, based on a result of the machine learning'.

The closest prior art document US 20190004518A1 discloses a method and system for training an unmanned aerial vehicle control model based on artificial intelligence, to improve the precision of the flight control system of the unmanned aerial vehicle, and achieve a controlling effect of strong inertia in a nonlinear complicated environment.

US 2020192340A1 discloses a method, performed by one or more data processing apparatus, for training an industrial plant controller that controls operation of an industrial plant. The method includes generating training data using an industrial plant simulation model that simulates operation of the industrial plant.

### SUMMARY

The invention is defined by the features of the independent claims. The dependent claims are directed to preferred embodiments of the invention.

A first aspect of the present invention provides a determination apparatus as defined in claim 1.

The determination unit may be configured to determine that the control of the control target by the control model is possible, when it is judged based on the simulation result that a period during which the asset can normally operate exceeds a predetermined threshold.

The determination unit may be configured to determine that the control of the control target by the control model is possible, when it is judged based on the simulation result that a number of times that it is judged that the asset can normally operate exceeds a predetermined threshold.

The determination apparatus may further comprise an output unit configured to output the simulation result, and the determination unit may be configured to determine that the control of the control target by the control model is possible, when an instruction to permit control is acquired in response to an output of the simulation result.

The determination apparatus comprises an instruction unit configured to instruct the control target to start control by the control model, when it is determined that the control of the control target by the control model is possible.

The control model generation unit may be configured to re-generate the control model by the machine learning, when it is determined that the control of the control target by the control model is not possible.

The determination apparatus may further comprise a convergence judgment unit configured to judge convergence of the machine learning, and the simulation unit may be configured to simulate the state of the asset when it is judged that the machine learning has converged.

The convergence judgment unit may be configured to judge the convergence of the machine learning, based on an elapsed time since the machine learning is started.

The convergence judgment unit may be configured to judge the convergence of the machine learning, based on a value of an evaluation function of the machine learning.

The control model generation unit may be configured to generate the control model by performing reinforcement learning so that an operation amount whose reward value determined by a predetermined reward function is higher is output as a recommended operation amount, in response to an input of the state data.

A second aspect of the present invention provides a determination method as defined in claim 11.

A third aspect of the present invention provides a determination computer program as defined in claim 12.

The summary clause does not necessarily describe all necessary features of the embodiments of the present invention.

### BRIEF DESCRIPTION OF THE DRAWINGS

Fig. 1 shows an example of a block diagram of a determination apparatus 100 according to the present embodiment, together with equipment 10 provided with a control target 20.
Fig. 2 shows an example of a flow where the determination apparatus 100 according to the present embodiment determines whether AI control is possible.
Fig. 3 shows an example of a block diagram of the determination apparatus 100 according to a modified embodiment of the present embodiment, together with the equipment 10 provided with the control target 20.
Fig. 4 shows an example of a flow where the determination apparatus 100 according to the modified embodiment of the present embodiment determines whether AI control is possible.
Fig. 5 shows an example of a block diagram of the determination apparatus 100 according to another modified embodiment of the present embodiment, together with the equipment 10 provided with the control target 20.
Fig. 6 shows an example of a flow where the determination apparatus 100 according to another modified embodiment of the present embodiment determines whether AI control is possible.
Fig. 7 shows an example of a computer 9900 in which a plurality of aspects of the present invention may be entirely or partially embodied.

### DESCRIPTION OF EXEMPLARY EMBODIMENTS

Hereinafter, the present invention will be described through embodiments of the invention, but the following embodiments do not limit the invention according to the claims. In addition, not all combinations of features described in the embodiments are essential to the solution of the invention.

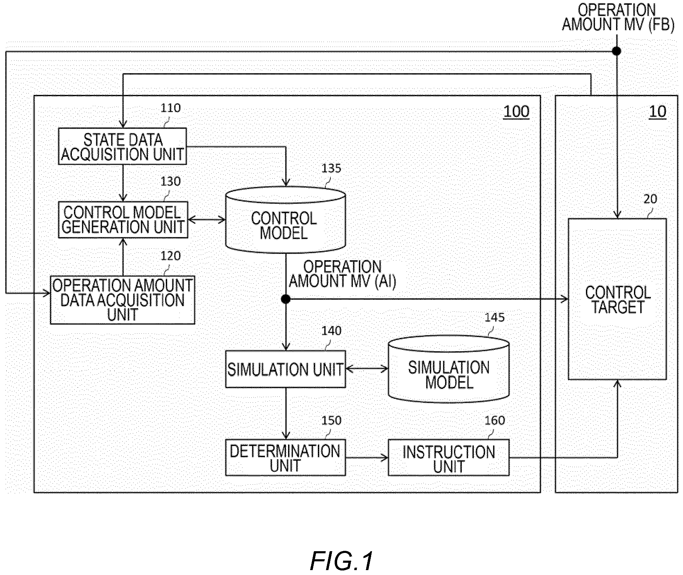

Fig. 1 shows an example of a block diagram of a determination apparatus 100 according to the present embodiment, together with equipment 10 provided with a control target 20. The determination apparatus 100 according to the present embodiment is configured, before starting control (also referred to as artificial intelligence (AI) control) for the control target 20 by a learning model generated by machine learning, to simulate a state of the equipment 10 in a case where an output of the learning model is given to the control target 20. The determination apparatus 100 according to the present embodiment is configured to determine whether the AI control is possible, based on a simulation result.

The equipment 10 is a system, an apparatus, or the like provided with the control target 20. For example, the equipment 10 may be a plant or a complex apparatus in which a plurality of devices is combined. Examples of the plant may include a plant for managing and controlling wells such as a gas field and an oilfield and surroundings thereof, a plant for managing and controlling hydroelectric, thermo electric and nuclear power generations and the like, a plant for managing and controlling environmental power generation such as solar power and wind power, a plant for managing and controlling water and sewerage, a dam and the like, and the like, in addition to chemical and bio industrial plants and the like.

The equipment 10 is provided with the control target 20. In the present drawing, a case where the equipment 10 is provided with only one control target 20 is shown as an example, but the present invention is not limited thereto. The equipment 10 may be provided with a plurality of control targets 20.

The equipment 10 may also be provided with one or more sensors (not shown) configured to measure a variety of states (physical quantities) inside and outside the equipment 10. Such sensors are configured to measure, for example, operation data, consumption data, external environment data, and the like.

Here, the operation data indicates an operation state as a result of controlling the control target 20. For example, the operation data may indicate a measured value PV (Process Variable) measured for the control target 20, and as an example, may indicate an output (control amount) of the control target 20, or a variety of values that are changed by an output of the control target 20.

The consumption data indicates an amount of consumption of at least one of energy or raw material in the equipment 10. For example, the consumption data may indicate an amount of consumption of electric power or fuel (as an example, LPG: Liquefied Petroleum Gas), as energy consumption.

The external environment data indicates a physical quantity that can act as a disturbance with respect to control of the control target 20. For example, the external environment data may indicate a temperature and a humidity of an outside air of the equipment 10, a sunshine, a wind direction, an air volume, an amount of precipitation, various physical quantities that change with control of other devices provided to the equipment 10, and the like.

The control target 20 is a device, an apparatus or the like that is a target of control. For example, the control target 20 may be an actuator such as a valve, a pump, a heater, a fan, a motor and a switch that is configured to control at least one physical quantity such as a pressure, a temperature, a pH, a speed or a flow rate in a process of the equipment 10, and is configured to input a given operation amount MV (Manipulated Variable) and to output a control amount.

In addition, the control target 20 can switch between feedback control by an operation amount MV (FB: FeedBack) given from a controller (not shown) and AI control by an operation amount MV (AI) given from the control model. Such FB control may be control using at least one of proportional control (P control), integral control (I control) or differential control (D control), for example, and may be, as an example, PID control. Note that, the controller may also be integrally configured as a part of the determination apparatus 100 according to the present embodiment, or may also be configured as a separate body independent of the determination apparatus 100.

The determination apparatus 100 according to the present embodiment is configured, before starting AI control (for example, starting AI control by switching from FB control to AI control) for the control target 20, to simulate a state of the equipment 10 in a case where an output of the learning model is given to the control target 20. The determination apparatus 100 according to the present embodiment is configured to determine whether the AI control is possible, based on a simulation result.

The determination apparatus 100 may be a computer such as a PC (personal computer), a tablet-type computer, a smart phone, a workstation, a server computer or a general-purpose computer, or a computer system where a plurality of computers is connected. Such computer system is also a computer in a broad sense. The determination apparatus 100 may also be implemented by one or more virtual computer environments that can be executed in the computer. Instead of this, the determination apparatus 100 may also be a dedicated computer designed for a determination as to whether control is possible or a dedicated hardware implemented by a dedicated circuitry. In a case where the determination apparatus 100 can be connected to the Internet, the determination apparatus 100 may also be implemented by cloud computing.

The determination apparatus 100 comprises a state data acquisition unit 110, an operation amount data acquisition unit 120, a control model generation unit 130, a control model 135, a simulation unit 140, a simulation model 145, a determination unit 150, and an instruction unit 160. Note that, these blocks are functional blocks that are each functionally divided, and may not be necessarily required to be matched with actual device configurations. That is, in the present drawing, a unit indicated by one block may not be necessarily required to be configured by one device. In addition, in the present drawing, units indicated by separate blocks may not be necessarily required to be configured by separate devices.

The state data acquisition unit 110 is configured to acquire state data indicative of a state of the equipment 10 provided with the control target 20. For example, the state data acquisition unit 110 is configured to acquire operation data, consumption data, external environment data and the like measured by sensors provided to the equipment 10 from the sensors via a network, as the state data. The state data acquisition unit 110 may also be configured to acquire such state data from an operator, or to acquire such state data from various memory devices and the like. The state data acquisition unit 110 is configured to supply the acquired state data to the control model generation unit 130. The state data acquisition unit 110 is also configured to supply the acquired state data to the control model 135.

The operation amount data acquisition unit 120 is configured to acquire operation amount data indicative of an operation amount of the control target 20. For example, the operation amount data acquisition unit 120 is configured to acquire data, which indicates an operation amount MV (FB) given from the controller (not shown) to the control target 20 when FB controlling the control target 20, from the controller, via the network. The operation amount data acquisition unit 120 may also be configured to acquire such operation amount data from an operator, or to acquire such operation amount data from various memory devices. The operation amount data acquisition unit 120 is configured to supply the acquired operation amount data to the control model generation unit 130.

The control model generation unit 130 is configured to generate a control model 135, which outputs an operation amount corresponding to the state of the equipment 10, by machine learning by using the state data and the operation amount data. For example, the control model generation unit 130 is configured to generate the control model 135, which outputs the operation amount MV (AI) corresponding to the state of the equipment 10, by reinforcement-learning, as learning data, the state data supplied from the state data acquisition unit 110 and the data indicative of the operation amount MV (FB) supplied from the operation amount data acquisition unit 120. That is, the control model generation unit 130 is configured to generate the control model 135 by performing reinforcement learning so that an operation amount whose reward value determined by a predetermined reward function is higher is output as a recommended operation amount, in response to an input of the state data. This will be described later in detail.

The control model 135 is a learning model generated as a result of the reinforcement learning by the control model generation unit 130, and is configured to output the operation amount MV (AI) corresponding to the state of the equipment 10. For example, the control model 135 is configured to input the state data supplied from the state data acquisition unit 110 and to output a recommended operation amount MV (AI) that is to be given to the control target 20 according to the state of the equipment 10. The control model 135 is configured to supply the output operation amount MV (AI) to the control target 20. The control model 135 is also configured to supply the output operation amount MV (AI) to the simulation unit 140. Note that, in the present drawing, a case where the control model 135 is built in the determination apparatus 100 is shown as an example. The control model 135 may also be stored in an apparatus different from the determination apparatus 100 (for example, on a cloud server). Further, in the present drawing, a case where when the control model 135 outputs the operation amount MV (Al), the output operation amount MV (AI) is always supplied to the control target 20 is shown as an example. The control model 135 may also be configured to supply the output operation amount MV (AI) to the control target 20 only when it is determined that the AI control is possible, as a result of determination to be described later.

The simulation unit 140 is configured, by using the simulation model 145, to simulate the state of the equipment 10 in a case where the operation amount MV (AI) output by the control model 135 is given to the control target 20. Note that, as used herein, 'simulating' includes a case where the simulation unit 140 causes another apparatus (for example, a simulator (not shown)) to simulate a state of the equipment 10 and acquires the state of the equipment 10 simulated by another apparatus from another apparatus, in addition to a case where the simulation unit 140 plays a central role in simulating the state of the equipment 10 by itself. For example, the simulation unit 140 is configured to input the operation amount MV (AI) output by the control model 135 into the simulation model 145, and to acquire a plurality of output values output by the simulation model 145, as a simulation result. The simulation unit 140 is configured to supply the acquired simulation result to the determination unit 150.

The simulation model 145 is a model (for example, a plant model) constructed to simulate a behavior of the equipment 10. For example, the simulation model 145 is configured to simulate a behavior of the equipment 10 in a case where the operation amount MV (AI) is input and the operation amount MV (AI) is given to the control target 20. Then, the simulation model 145 is configured to output a plurality of output values indicative of the simulated state of the equipment 10. As an example, the simulation model 145 may be a simple physical model having a relatively light processing load or a relatively low-order linear model so as to be able to simulate a behavior of the equipment 10 with a same cycle as or with a shorter cycle than a control cycle of the equipment 10. Note that, in the present drawing, a case where the simulation model 145 is built in the determination apparatus 100 is shown as an example. Similar to the control model 135, the simulation model 145 may also be stored in an apparatus different from the determination apparatus 100 (for example, on a cloud server). In addition, the above-described simulator may also be provided to an apparatus different from the determination apparatus 100.

The determination unit 150 is configured to determine whether the control of the control target 20 by the control model 135 is possible, based on a simulation result. For example, the determination unit 150 is configured to determine whether the simulation result supplied from the simulation unit 140 satisfies a predetermined condition (for example, an abnormality diagnosis condition). When the simulation result does not satisfy the predetermined condition, the determination unit 150 is configured to determine that the control of the control target 20 by the control model 135 is possible, and when the simulation result satisfies the predetermined condition, the determination unit is configured to determine that the control of the control target 20 by the control model 135 is not possible. The determination unit 150 is configured to supply a determination result to the instruction unit 160.

When it is determined that the control of the control target 20 by the control model 135 is possible, the instruction unit 160 is configured to instruct the control target 20 to start control by the control model 135. At this time, the instruction unit 160 may be configured to issue an instruction directly to the control target 20. Thereby, for example, the control target 20 is configured to switch from FB control by the operation amount MV (FB) given from the controller to the AI control by the operation amount MV (AI) given from the control model 135, and to start the AI control. In addition, for example, in a case where another controller such as a PID controller is integrally configured as a part of the determination apparatus 100, the instruction unit 160 may be configured to issue an instruction to a switching unit capable of switching whether to output either the operation amount MV (FB) or the operation amount MV (AI) to the control target 20. Thereby, the operation amount MV output from the determination apparatus 100 to the control target 20 may be switched from the operation amount MV (FB) to the operation amount MV (Al), and the AI control may be started for the control target 20.

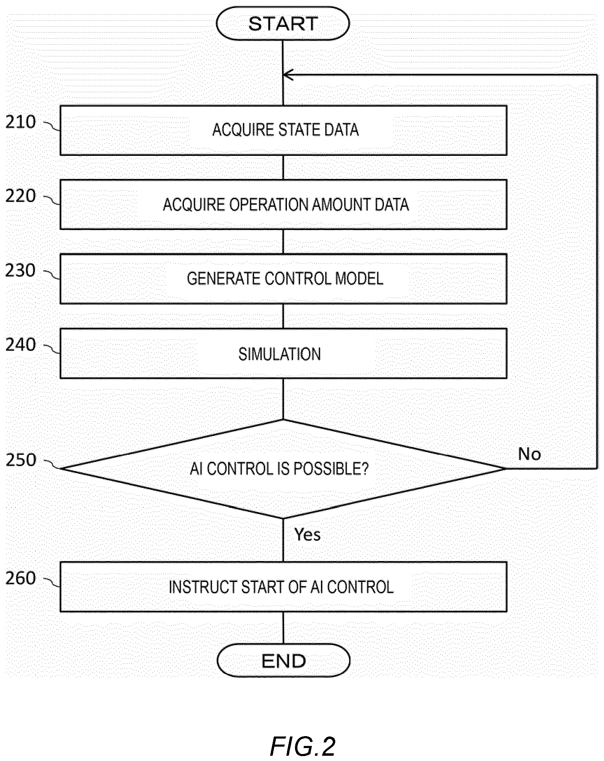

Fig. 2 shows an example of a flow where the determination apparatus 100 according to the present embodiment determines whether AI control is possible.

In step 210, the determination apparatus 100 acquires state data. For example, the state data acquisition unit 110 acquires state data indicative of a state of the equipment 10 provided with the control target 20. As an example, the state data acquisition unit 110 acquires operation data, consumption data, external environment data and the like measured by the sensors provided to the equipment 10 from the sensors via the network, as the state data. The state data acquisition unit 110 supplies the acquired state data to the control model generation unit 130 and the control model 135.

In step 220, the determination apparatus 100 acquires operation amount data. For example, the operation amount data acquisition unit 120 acquires operation amount data indicative of an operation amount of the control target 20. As an example, the operation amount data acquisition unit 120 acquires data, which indicates an operation amount MV (FB) given from the controller to the control target 20 when FB controlling the control target 20, from the controller, via the network. The operation amount data acquisition unit 120 supplies the acquired operation amount data to the control model generation unit 130. Note that, in the present drawing, a case where the determination apparatus 100 acquires the operation amount data after acquiring the state data is shown as an example. The determination apparatus 100 may also acquire the state data after acquiring the operation amount data or may also acquire the state data and the operation amount data at the same time.

In step 230, the determination apparatus 100 generates the control model 135. For example, the control model generation unit 130 generates the control model 135, which outputs an operation amount corresponding to the state of the equipment 10, by machine learning by using the state data and the operation amount data. As an example, the control model generation unit 130 generates the control model 135, which outputs the operation amount MV (AI) corresponding to the state of the equipment 10, by reinforcement-learning, as learning data, the state data acquired in step 210 and the data indicative of the operation amount MV (FB) acquired in step 220.

In general, when an agent observes a state of an environment and selects a certain action, the environment changes based on the action. In reinforcement learning, a certain reward is given in association with such change in the environment, so that the agent learns selection of a better action (decision-making). In supervised learning, a complete correct answer is given, whereas in reinforcement learning, a reward is given as a fragmentary value based on some change in the environment. For this reason, the agent learns to select an action that maximizes a total reward in the future. In this way, in reinforcement learning, the agent learns an appropriate action, considering an interaction that an action has on the environment by learning the action, i.e., an action for maximizing a reward that will be obtained in the future.

In the present embodiment, the reward in such reinforcement learning may be an index for evaluating an operation of the equipment 10 or may be a value determined by a predetermined reward function. As used herein, the function is a mapping having a rule of correlating each element of a certain set and each element of another set on one-to-one correspondence, and may be, for example, a mathematical formula or a table.

The reward function outputs a value (reward value) that is generated by evaluating the state of the equipment 10 indicated by the state data, in response to the input of the state data. As described above, for example, the state data includes the measured value PV measured for the control target 20. Therefore, the reward function may be defined as a function in which the reward value becomes higher as such measured value PV is closer to a target value SV (Setting Variable). Here, a function whose variable is an absolute value of a difference between the measured value PV and the target value SV is defined as an evaluation function. That is, as an example, in a case where the control target 20 is a valve, the evaluation function may be a function whose variable is an absolute value of a difference between the measured value PV, which is an opening degree of the valve actually measured by a sensor, and the target value SV, which is a target opening degree of the valve. The reward function may be a function whose variable is a value of the evaluation function obtained by such evaluation function.

Further, as described above, the state data includes, for example, various values that change depending on an output of the control target 20, consumption data, external environment data, and the like, in addition to the measured value PV. Therefore, the reward function may be a function that increases or decreases the reward value based on such various values, consumption data, external environment data, and the like. As an example, in a case where there are constraints that should be observed with respect to such various values and consumption data, the reward function may be a function that minimizes the reward value, if such various values and consumption data do not satisfy constraint conditions, in light of the external environment data. Further, in a case where there are targets that are to be aimed with respect to such various values and consumption data, the reward function may be a function that increases the reward value as such various values and consumption data are closer to the targets and decreases the reward value as such various values and consumption data are farther from the targets, in light of the external environment data.

The control model generation unit 130 acquires the reward value in each learning data, based on such reward function. Then, the control model generation unit 130 performs reinforcement learning by using each set of learning data and reward value. At this time, the control model generation unit 130 may perform learning processing by a known method such as a steepest descent method, a neural network, a DQN (Deep Q-Network), a Gaussian process and deep learning. Then, the control model generation unit 130 learns so that an operation amount whose reward value is higher is preferentially output as a recommended operation amount. That is, the control model generation unit 130 generates the control model 135 by performing reinforcement learning so that an operation amount whose reward value determined by a predetermined reward function is higher is output as a recommended operation amount, in response to an input of the state data. Thereby, the model is updated and the control model 135 is generated.

In step 240, the determination apparatus 100 executes simulation. For example, the simulation unit 140 simulates, by using the simulation model 145, the state of the equipment 10 in a case where the operation amount MV (AI) output by the control model 135 is given to the control target 20. As an example, the simulation unit 140 inputs, to the simulation model 145, the operation amount MV (AI) output by the control model 135 generated in step 230, and acquires a plurality of output values output by the simulation model, as a simulation result. The simulation unit 140 supplies the acquired simulation result to the determination unit 150.

In step 250, the determination apparatus 100 determines whether the AI control is possible. For example, the determination unit 150 determines whether the control of the control target 20 by the control model 135 is possible, based on the simulation result. As an example, the determination unit 150 determines whether the simulation result in step 240 satisfies a predetermined condition. At this time, for example, the determination unit 150 may store in advance an abnormality diagnosis condition for diagnosing an abnormality in the equipment 10. When all of the plurality of output values output by the simulation model 145 do not satisfy the abnormality diagnosis condition, the determination unit 150 may infer that the equipment 10 can normally operate. In addition, when at least one of the plurality of output values output by the simulation model 145 satisfies the abnormality diagnosis condition, the determination unit 150 may infer that the equipment 10 cannot normally operate (an abnormality occurs in the equipment). The determination unit 150 may determine that the control of the control target 20 by the control model 135 is possible, when it is judged based on the simulation result that a period during which the equipment 10 can normally operate exceeds a predetermined threshold. That is, the determination unit 150 may determine that the AI control is possible, when it is judged that the equipment 10 can normally operate in excess of a predetermined period P. In addition, the determination unit 150 may determine that the control of the control target 20 by the control model 135 is possible, when it is judged based on the simulation result that a number of times that it is judged that the equipment 10 can normally operate exceeds a predetermined threshold. That is, the determination unit 150 may determine that the AI control is possible, when the number of times that it is judged that the equipment 10 can normally operate exceeds N times, which is a predetermined number of times. Further, the determination unit 150 may use the determination based on the period and the determination based on the number of times in combination. For example, the determination unit 150 may determine that the AI control is possible, when the period for which it is judged that the normal operation is possible exceeds the period P and the number of times that it is judged that the normal operation is possible exceeds N times. Further, the determination unit 150 may determine that the AI control is possible, when a number of times that the period for which it is judged that the normal operation is possible exceeds the period P exceeds N times. The determination unit 150 supplies a determination result to the instruction unit 160.

In step 250, when it is determined that the AI control is not possible (No), the determination apparatus 100 returns the processing to step 210 and continues the flow. That is, when it is determined that the control of the control target 20 by the control model 135 is not possible, the control model generation unit 130 re-generates the control model 135 by machine learning.

In step 250, when it is determined that the AI control is possible (Yes), the determination apparatus 100 advances the processing to step 260 and instructs the control target 20 for start of the AI control. For example, when it is determined that the control of the control target 20 by the control model 135 is possible, the instruction unit 160 instructs the control target 20 to start control by the control model 135. Thereby, for example, the control target 20 is configured to switch from FB control by the operation amount MV (FB) given from the controller to the AI control by the operation amount MV (AI) given from the control model 135, and to start the AI control.

In general, machine learning uses input data to determine a parameter of a learning model, which is stochastically obtained and is not theoretically guaranteed. For this reason, abnormal inference data may be output from the learning model. Therefore, the determination apparatus 100 according to the present embodiment simulates, by using the simulation model 145, the state of the equipment 10 in a case where the operation amount MV (AI) output by the control model 135 is given to the control target 20, before starting the AI control. Then, the determination apparatus 100 determines whether the AI control is possible, based on the simulation result. Thereby, according to the determination apparatus 100 of the present embodiment, it is possible to prevent in advance the equipment 10 from behaving abnormally with the AI control after the AI control is put into an actual machine, i.e., after an operation of the equipment 10 is started by the AI control. Here, it is also considered to determine whether the AI control is possible, based on whether the operation amount MV (AI) output by the control model 135 satisfies a predetermined standard. However, such standard is given artificially and empirically, and, it cannot be said that even if the operation amount MV (AI) satisfies such standard, an abnormality does not always occur in the equipment 10. Similarly, it cannot be said that even if the operation amount MV (AI) does not satisfy such standard, an abnormality always occurs in the equipment 10. In contrast, according to the determination apparatus 100 of the present embodiment, it is determined whether the AI control is possible, based on the result of simulating the state of the equipment 10 in a case where the operation amount MV (AI) is given to the control target 20, not based on the operation amount MV (AI) itself. Therefore, it is possible to determine whether the AI control is possible, based on a basis closer to the actual operation.

In addition, the determination apparatus 100 of the present embodiment determines that the AI control is possible, when the period during which the equipment 10 can normally operate exceeds the threshold or when the number of times that it is judged that the equipment can normally operate exceeds the threshold, based on the simulation result. Thereby, according to the determination apparatus 100 of the present embodiment, it is determined that the AI control is possible, after observing for a while that the normal operation is possible. Therefore, when the operation amount MV (AI) is given to the control target 20, it is possible to avoid erroneous determination that the AI control is possible even for a case where it has been inferred by chance that an abnormality does not occur in the equipment 10.

Further, the determination apparatus 100 of the present embodiment instructs the control target 20 to switch to the control by the control model 135 when it is determined that the AI control is possible. Thereby, according to the determination apparatus 100 of the present embodiment, it is possible to instruct the control target 20 for start of the AI control by using the determination based on the simulation result as a trigger. Further, the determination apparatus 100 of the present embodiment re-generates the control model 135 by machine learning when it is determined that the AI control is not possible. Thereby, according to the determination apparatus 100 of the present embodiment, even when it is once determined that the AI control is not possible, the learning is again performed to re-generate the control model, and it is possible to repeatedly determine whether the AI control is possible by the re-generated control model 135.

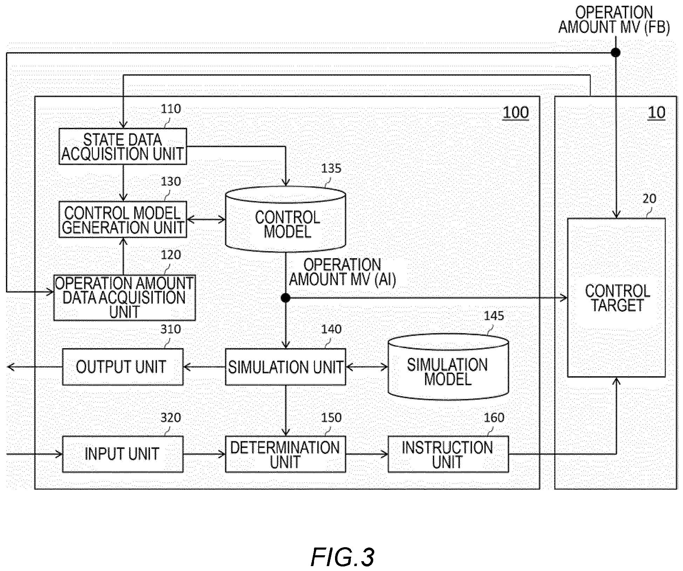

Fig. 3 shows an example of a block diagram of the determination apparatus 100 according to a modified embodiment of the present embodiment, together with the equipment 10 provided with the control target 20. In Fig. 3, the members having same functions and configurations as those in Fig. 1 are denoted with the same reference signs, and descriptions thereof are omitted, except for differences to be described below. In the determination apparatus 100 according to the above-described embodiment, the case where it is automatically determined whether the AI control is possible, based on the simulation result, has been shown as an example. However, in the determination apparatus 100 according to the present modified embodiment, the simulation result is output, and it is determined whether the AI control is possible, based on a permission from an operator or the like who has examined the simulation result. The determination apparatus 100 according to the present modified embodiment further comprises an output unit 310 and an input unit 320.

In the determination apparatus 100 according to the present modified embodiment, the simulation unit 140 is configured to supply a simulation result to the output unit 310, in addition to the determination unit 150. The output unit 310 is configured to output the simulation result. For example, the output unit 310 may also be configured to output the simulation result by displaying the same on a monitor, to output the simulation result by printing the same out, or to output the simulation result by data-transmitting the same to another apparatus.

The input unit 320 is configured to receive a user input from an operator or the like who has examined the simulation result, in response to the output of the simulation result. The input unit 320 is configured to supply a user-input instruction from the operator to the determination unit 150.

The determination unit 150 is configured to determine that the control of the control target 20 by the control model 135 is possible, when the instruction supplied from the input unit 320 indicates that the AI control is permitted. That is, the determination unit 150 is configured to determine that the control of the control target 20 by the control model 135 is possible, when an instruction to permit control is acquired in response to the output of the simulation result.

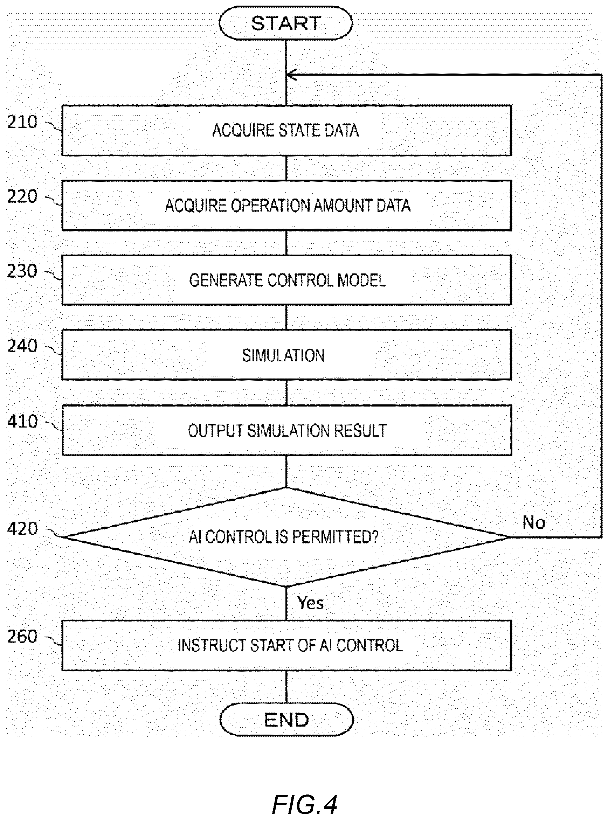

Fig. 4 shows an example of a flow where the determination apparatus 100 according to the modified embodiment of the present embodiment determines whether AI control is possible. In Fig. 4, the same processings as those in Fig. 2 are denoted with the same reference signs, and descriptions thereof are omitted, except for differences to be described below. In the present flow, steps 410 and 420 are provided, instead of step 250.

In step 410, the determination apparatus 100 outputs a simulation result. For example, the output unit 310 acquires a simulation result of the simulation unit 140 performed in step 240 and displays the simulation result on the monitor to output the simulation result.

In step 420, the determination apparatus 100 determines whether the AI control is permitted. For example, the determination unit 150 determines whether an instruction to permit the AI control has been acquired from the operator or the like who has examined the simulation result, via the input unit 320. In step 420, when an instruction to permit the AI control has not been acquired (in the case of No), the determination unit 150 determines that the AI control is not possible. Then, the determination apparatus 100 returns the processing to step 210 and continues the flow. In step 420, when an instruction to permit the AI control has been acquired (in the case of Yes), the determination unit 150 determines that the AI control is possible. Then, the determination apparatus 100 advances the processing to step 260. That is, the determination unit 150 determines that the control of the control target 20 by the control model 135 is possible, when an instruction to permit control is acquired in response to the output of the simulation result (in the case of Yes).

As described above, the determination apparatus 100 according to the present modified embodiment outputs the simulation result, and determines whether the AI control is possible, based on the instruction from the operator or the like who has examined the simulation result. Thereby, according to the determination apparatus 100 of the present modified embodiment, it is possible to reflect an intention of the operator or the like when putting the AI control into the actual machine.

Note that, in the above descriptions, the case where the determination apparatus 100 executes steps 410 and 420 instead of step 250 has been shown as an example. The determination apparatus 100 according to the present modified embodiment may execute steps 410 and 420, in addition to step 250. At this time, the determination apparatus 100 may determine that the AI control is possible, when at least one of the permission instruction by the operator or the like and the automatic determination by a computer (for example, the determination based on the period or the number of times that it is judged that the normal operation is possible) is satisfied. Instead of this, the determination apparatus 100 may firstly determine that the AI control is possible when both the permission instruction by the operator or the like and the automatic determination by the computer are satisfied. Thereby, according to the determination apparatus 100 of the present modified embodiment, it is possible to more carefully determine the putting of the AI control into the actual machine by using the automatic determination by the computer and the manual determination by the operator in combination.

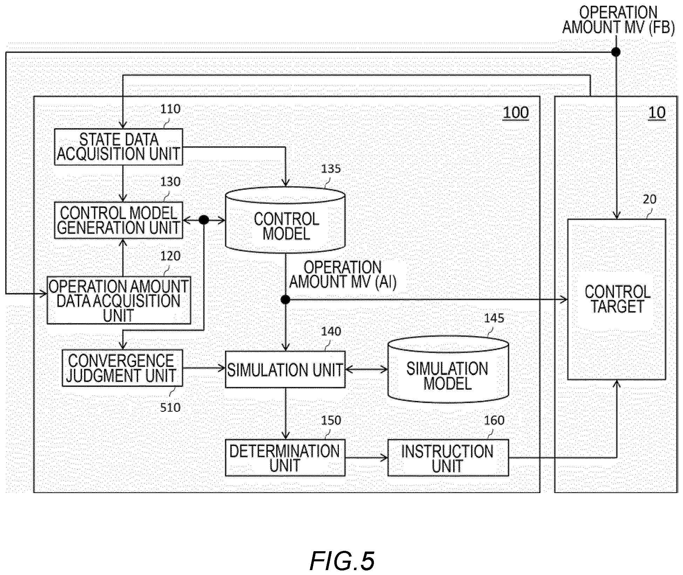

Fig. 5 shows an example of a block diagram of the determination apparatus 100 according to another modified embodiment of the present embodiment, together with the equipment 10 provided with the control target 20. In Fig. 5, the members having same functions and configurations as those in Fig. 1 are denoted with the same reference signs, and descriptions thereof are omitted, except for differences to be described below. In the determination apparatus 100 according to the above-described embodiment, the case where when the control model 135 outputs the operation amount MV (Al), the state of the equipment 10 in a case where the operation amount MV (AI) is given to the control target 20 is always simulated has been shown as an example. However, in the determination apparatus 100 according to another modified embodiment, a trigger for simulating the state of the equipment 10 is provided according to a progress of the machine learning for generating the control model 135. The determination apparatus 100 according to another modified embodiment further comprises a convergence judgment unit 510.

The convergence judgment unit 510 is configured to monitor a progress of machine learning for the control model generation unit 130 to generate the control model 135. The convergence judgment unit 510 is configured to judge convergence of the machine learning for generating the control model 135. When it is judged that the machine learning has converged, the convergence judgment unit 510 is configured to instruct the simulation unit 140 to simulate a state of the equipment 10. In response to this, the simulation unit 140 is configured to simulate a state of the equipment 10. That is, the simulation unit 140 is configured to simulate a state of the equipment 10 when it is judged that the machine learning has converged.

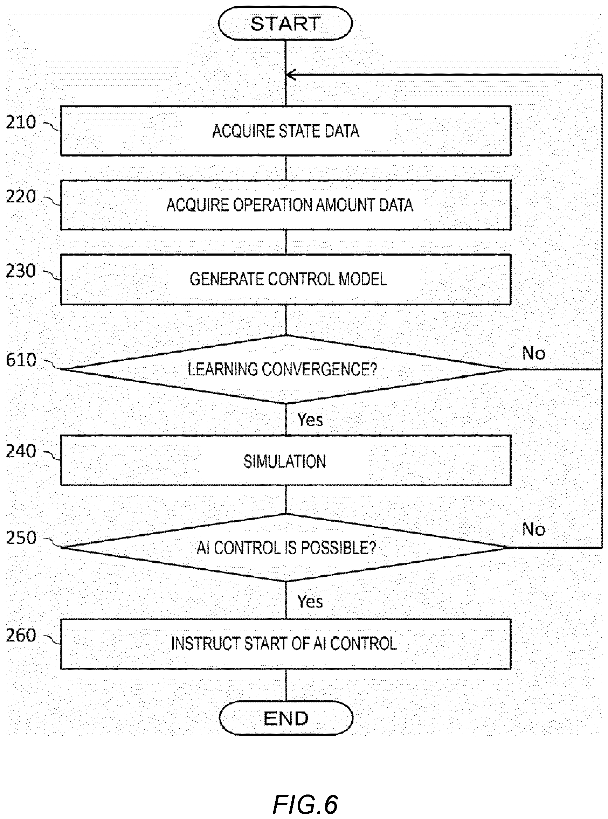

Fig. 6 shows an example of a flow where the determination apparatus 100 according to another modified embodiment of the present embodiment determines whether AI control is possible. In Fig. 6, the same processings as those in Fig. 2 are denoted with the same reference signs, and descriptions thereof are omitted, except for differences to be described below. In the present flow, a step 610 is further provided.

In step 610, the determination apparatus 100 judges convergence of the machine learning. For example, the convergence judgment unit 510 monitors a progress of machine learning for the control model generation unit 130 to generate the control model 135, and judges convergence of the machine learning for generating the control model 135. At this time, the convergence judgment unit 510 may judge the convergence of the machine learning, based on an elapsed time since the machine learning is started. Instead of this or additionally, the convergence judgment unit 510 may judge the convergence of the machine learning, based on a value of an evaluation function of the machine learning. For example, the convergence judgment unit 510 may judge that the machine learning has converged, when at least one of a minimum value, a maximum value, an average value, a median value or the like in the value of the evaluation function that is a function whose variable is an absolute value of a difference between the measured value PV and the target value SV falls below a predetermined threshold.

In step 610, when it is judged that the machine learning has not converged (in the case of No), the determination apparatus 100 returns the processing to step 210 and continues the flow. In step 610, when it is judged that the machine learning has converged (in the case of Yes), the determination apparatus 100 advances the processing to step 240. That is, the simulation unit 140 simulates a state of the equipment 10 when it is judged that the machine learning has converged.

In this way, the determination apparatus 100 according to another modified embodiment provides a trigger for simulating the state of the equipment 10, according to a progress of the machine learning for generating the control model 135. Thereby, according to the determination apparatus 100 of another modified embodiment, since it is possible to avoid simulating the state of the equipment 10 even in a case where the machine learning has not converged, it is possible to reduce the processing load of the determination apparatus 100. In addition, according to the determination apparatus 100 of another modified embodiment, since the state of the equipment 10 is simulated after the learning convergence, it is possible to improve the reliability of the simulation result for determining whether the AI control is possible.

At this time, the determination apparatus 100 according to another modified embodiment judges the convergence of the machine learning, based on the elapsed time since the machine learning is started, for example. Thereby, according to the determination apparatus 100 of another modified embodiment, it is possible to tentatively judge the convergence of the machine learning, based on the elapsed time. In addition, the determination apparatus 100 according to another modified embodiment judges the convergence of the machine learning, based on the value function of the machine learning, for example. Thereby, according to the determination apparatus 100 of another modified embodiment, it is possible to judge the convergence of the machine learning, based on an objective value. Note that, when judging the convergence of the machine learning, the determination apparatus 100 according to another modified embodiment may use the judgment based on the elapsed time and the judgment based on the value function in combination. Thereby, according to the determination apparatus 100 of another modified embodiment, since the simulation is triggered only when the machine learning is performed for a long time and a result of the machine learning satisfies a predetermined standard, it is possible to further reduce the processing load of the determination apparatus 100.

Various embodiments of the present invention may be described with reference to flowcharts and block diagrams whose blocks may represent (1) steps of processes in which operations are performed or (2) sections of apparatuses responsible for performing operations. Certain steps and sections may be implemented by dedicated circuitry, programmable circuitry supplied with computer-readable instructions stored on computer-readable media, and/or processors supplied with computer-readable instructions stored on computer-readable media. The dedicated circuitry may include a digital and/or analog hardware circuit, or may include an integrated circuit (IC) and/or a discrete circuit. The programmable circuitry may include a reconfigurable hardware circuit including logical AND, logical OR, logical XOR, logical NAND, logical NOR, and other logical operations, a memory element such as a flip-flop, a register, a field programmable gate array (FPGA) and a programmable logic array (PLA), and the like.

Computer-readable media may include any tangible device that can store instructions to be executed by a suitable device, and as a result, the computer-readable storage medium having the instructions stored thereon comprises an article of manufacture including instructions that can be executed to provide means for performing operations specified in the flowcharts or block diagrams. Examples of computer-readable media may include an electronic storage medium, a magnetic storage medium, an optical storage medium, an electromagnetic storage medium, a semiconductor storage medium, and the like. More specific examples of computer-readable media may include a floppy (registered trademark) disk, a diskette, a hard disk, a random access memory (RAM), a read-only memory (ROM), an erasable programmable read-only memory (EPROM or flash memory (registered trademark)), an electrically erasable programmable read-only memory (EEPROM), a static random access memory (SRAM), a compact disc read-only memory (CD-ROM), a digital versatile disk (DVD), a BLU-RAY (registered trademark) disk, a memory stick, an integrated circuit card, and the like.

Computer-readable instructions may include assembler instructions, instruction-set-architecture (ISA) instructions, machine instructions, machine dependent instructions, microcode, firmware instructions, state-setting data, or either source code or object code described in any combination of one or more programming languages, including an object oriented programming language such as Smalltalk (registered trademark), JAVA (registered trademark) and C++, and a conventional procedural programming language such as a 'C' programming language or similar programming languages.

Computer-readable instructions may be provided to a processor of a general purpose computer, a special purpose computer, or other programmable data processing apparatus, or to a programmable circuitry, locally or via a local area network (LAN), wide area network (WAN) such as the Internet, etc., and the computer-readable instructions may be executed to provide means for performing operations specified in the flowcharts or block diagrams. Examples of processors include computer processors, processing units, microprocessors, digital signal processors, controllers, microcontrollers, and the like.

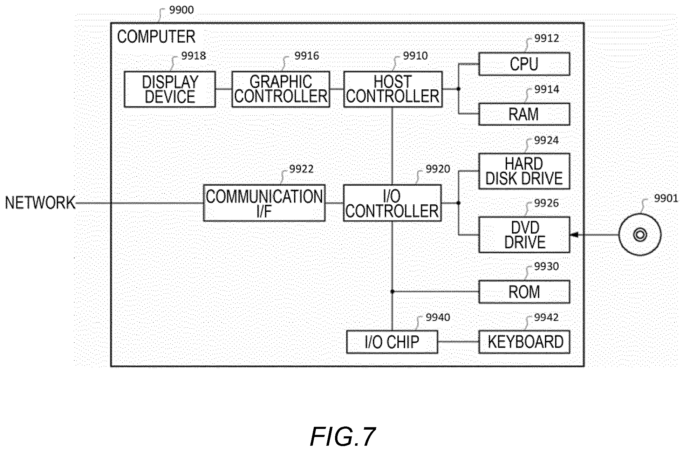

Fig. 7 shows an example of a computer 9900 where a plurality of aspects of the present invention may be entirely or partially embodied. A program that is installed in the computer 9900 can cause the computer 9900 to function as or execute operations associated with the apparatus of the embodiment of the present invention or one or more sections of the apparatus, and/or cause the computer 9900 to execute the process of the embodiment of the present invention or steps thereof. Such program may be executed by a CPU 9912 so as to cause the computer 9900 to execute certain operations associated with some or all of the blocks of flowcharts and block diagrams described herein.

The computer 9900 according to the present embodiment includes the CPU 9912, a RAM 9914, a graphic controller 9916 and a display device 9918, which are mutually connected by a host controller 9910. The computer 9900 also includes input and output units such as a communication interface 9922, a hard disk drive 9924, a DVD drive 9926 and an IC card drive, which are connected to the host controller 9910 via an input and output controller 9920. The computer also includes legacy input and output units such as a ROM 9930 and a keyboard 9942, which are connected to the input and output controller 9920 via an input and output chip 9940.

The CPU 9912 is configured to operate according to programs stored in the ROM 9930 and the RAM 9914, thereby controlling each unit. The graphic controller 9916 is configured to acquire image data generated by the CPU 9912 on a frame buffer or the like provided in the RAM 9914 or in itself, and to cause the image data to be displayed on the display device 9918.

The communication interface 9922 is configured to communicate with other electronic devices via a network. The hard disk drive 9924 is configured to store programs and data that are used by the CPU 9912 within the computer 9900. The DVD drive 9926 is configured to read programs or data from a DVD-ROM 9901, and to provide the hard disk drive 9924 with the programs or data via the RAM 9914. The IC card drive is configured to read programs and data from an IC card, and/or to write programs and data into the IC card.

The ROM 9930 is configured to store therein a boot program or the like that is executed by the computer 9900 at the time of activation, and/or a program depending on the hardware of the computer 9900. The input and output chip 9940 may also be configured to connect various input and output units to the input and output controller 9920 via a parallel port, a serial port, a keyboard port, a mouse port and the like.

A program is provided by a computer-readable medium such as the DVD-ROM 9901 or the IC card. The program is read from the computer-readable medium, is installed into the hard disk drive 9924, the RAM 9914 or the ROM 9930, which are also examples of the computer-readable medium, and is executed by the CPU 9912. Information processing described in these programs is read into the computer 9900, resulting in cooperation between the programs and the various types of hardware resources described above. An apparatus or method may be constituted by realizing an operation or processing of information according to a use of the computer 9900.

For example, when communication is performed between the computer 9900 and an external device, the CPU 9912 may be configured to execute a communication program loaded onto the RAM 9914 to instruct the communication interface 9922 for communication processing, based on processing described in the communication program. The communication interface 9922 is configured, under control of the CPU 9912, to read transmission data stored on a transmission buffer processing area provided in a recording medium such as the RAM 9914, the hard disk drive 9924, the DVD-ROM 9901 or the IC card, and to transmit the read transmission data to a network or to write reception data received from the network to a reception buffer processing area or the like provided on the recording medium.

In addition, the CPU 9912 may be configured to cause all or a necessary portion of a file or a database, which has been stored in an external recording medium such as the hard disk drive 9924, the DVD drive 9926 (DVD-ROM 9901) and the IC card, to be read into the RAM 9914, thereby executing various types of processing on the data on the RAM 9914. Next, the CPU 9912 is configured to write the processed data back to the external recording medium.

Various types of information, such as various types of programs, data, tables, and databases, may be stored in the recording medium and may be subjected to information processing. The CPU 9912 may be configured to execute, on the data read from the RAM 9914, various types of processing including various types of operations, processing of information, conditional judgment, conditional branching, unconditional branching, search and replacement of information and the like described in the present disclosure and specified by instruction sequences of the programs, and to write a result back to the RAM 9914. The CPU 9912 may also be configured to search for information in a file, a database, etc., in the recording medium. For example, when a plurality of entries, each having an attribute value of a first attribute associated with an attribute value of a second attribute, is stored in the recording medium, the CPU 9912 may be configured to search for an entry having a designated attribute value of the first attribute that matches a condition from the plurality of entries, and to read the attribute value of the second attribute stored in the entry, thereby acquiring the attribute value of the second attribute associated with the first attribute that satisfies a predetermined condition.

The programs or software modules described above may be stored in the computer-readable medium on the computer 9900 or near the computer 9900. In addition, a recording medium such as a hard disk or a RAM provided in a server system connected to a dedicated communication network or the Internet can be used as a computer-readable medium, thereby providing the programs to the computer 9900 via the network.

While the present invention has been described using the embodiments, the technical scope of the present invention is not limited to the above-described embodiments. It is apparent to persons skilled in the art that various alterations and improvements can be added to the above-described embodiments.

The operations, procedures, steps, stages and the like of each process performed by an apparatus, system, program, and method shown in the claims, embodiments, or diagrams can be performed in any order as long as the order is not indicated by 'prior to,' 'before,' or the like and as long as the output from a previous process is not used in a later process. Even if the process flow is described using phrases such as 'first' or 'next' in the claims, embodiments, or diagrams, it does not necessarily mean that the process must be performed in this order.

### EXPLANATION OF REFERENCES

10: equipment
20: control target
100: determination apparatus
110: state data acquisition unit
120: operation amount data acquisition unit
130: control model generation unit
135: control model
140: simulation unit
145: simulation model
150: determination unit
160: instruction unit
310: output unit
320: input unit
510: convergence judgment unit
9900: computer
9901: DVD-ROM
9910: host controller
9912: CPU
9914: RAM
9916: graphic controller
9918: display device
9920: input and output controller
9922: communication interface
9924: hard disk drive
9926: DVD drive
9930: ROM
9940: input and output chip
9942: keyboard

## Claims

1. A determination apparatus (100) comprising:
a state data acquisition unit (110) configured to acquire state data indicative of a state of equipment (10) provided with a control target (20);
an operation amount data acquisition unit (120) configured to acquire operation amount data indicative of an operation amount of the control target (20);
a control model generation unit (130) configured to generate a control model (135), which outputs the operation amount corresponding to the state of the equipment (10), by machine learning by using the state data and the operation amount data
a simulation unit (140) configured to input the operation amount supplied from the control model (135) into a simulation model (145) to simulate the state of the equipment (10) in a case where the operation amount output by the control model (135) is given to the control target (20);
a determination unit (150) configured to determine whether control of the control target (20) by the control model (135) is possible, based on a simulation result supplied from the simulation unit (140);
**characterized by**
an instruction unit (160) configured to instruct the control target (20) to start the control by the operation amount supplied from the control model (135) to the control target (20) when it is determined that the control of the control target (20) by the control model (135) is possible, wherein
the state data comprises operation data, consumption data and external environment data measured by sensors provided to the equipment (10).

2. The determination apparatus (100) according to Claim 1, wherein
the determination unit (150) is configured to determine that the control of the control target (20) by the control model (135) is possible, when it is judged based on the simulation result that a period during which the equipment (10) can normally operate exceeds a predetermined threshold.

3. The determination apparatus (100) according to Claim 1 or 2, wherein
the determination unit (150) is configured to determine that the control of the control target (20) by the control model (135) is possible, when it is judged based on the simulation result that a number of times that it is judged that the equipment (10) can normally operate exceeds a predetermined threshold.

4. The determination apparatus (100) according to any one of Claims 1 to 3, further comprising an output unit configured to output the simulation result, wherein
the determination unit (150) is configured to determine that the control of the control target (20) by the control model (135) is possible, when an instruction to permit control is acquired in response to an output of the simulation result.

5. The determination apparatus (100) according to any one of Claims 1 to 4, wherein
the control model generation unit (130) is configured to re-generate the control model (135) by the machine learning, when it is determined that the control of the control target (20) by the control model (135) is not possible.

6. The determination apparatus (100) according to any one of Claims 1 to 5, further comprising a convergence judgment unit configured to judge convergence of the machine learning, wherein
the simulation unit (140) is configured to simulate the state of the equipment (10) when it is judged that the machine learning has converged.

7. The determination apparatus (100) according to Claim 6, wherein
the convergence judgment unit is configured to judge the convergence of the machine learning, based on an elapsed time since the machine learning is started.

8. The determination apparatus (100) according to Claim 6 or 7, wherein
the convergence judgment unit is configured to judge the convergence of the machine learning, based on a value of an evaluation function of the machine learning.

9. The determination apparatus (100) according to any one of Claims 1 to 8, wherein
the control model generation unit (130) is configured to generate the control model (135) by performing reinforcement learning so that an operation amount whose reward value determined by a predetermined reward function is higher is output as a recommended operation amount, in response to an input of the state data.

10. The determination apparatus according to Claim 1, wherein
the control target (20) is configured to switch between a feedback control by a second operation amount given from a controller and an artificial intelligence control by the operation amount supplied from the control model (135), and
the instruction unit (160) is configured to instruct the control target (20) to switch from the feedback control by the second operation amount to the artificial intelligence control by the operation amount supplied from the control model (135) when it is determined that the control of the control target (20) by the control model (135) is possible.

11. A determination method comprising:
acquiring state data indicative of a state of an equipment (10) provided with a control target (20);
acquiring operation amount data indicative of an operation amount of the control target (20)
generating a control model (135), which outputs the operation amount corresponding to the state of the equipment (10), by machine learning by using the state data and the operation amount data;
inputting the operation amount supplied from the control model (135) into a simulation model (145) to simulate the state of the equipment (10) in a case where the operation amount output by the control model (135) is given to the control target (20);
determining whether control of the control target (20) by the control model (135) is possible, based on a simulation result supplied by the simulating of the state of the equipment (10);
**characterized by**
instructing the control target (20) to start the control by the operation amount supplied from the control model (135) to the control target (20) when it is determined that the control of the control target (20) by the control model (135) is possible, wherein
the state data comprises operation data, consumption data and external environment data measured by sensors provided to the equipment (10).

12. A determination computer program comprising instructions which, when the program is executed by a computer, cause the computer to carry out the steps of the method of claim 11.

## Patentansprüche

1. Bestimmungsvorrichtung (100), die aufweist:
eine Zustandsdatenbeschaffungseinheit (110), die ausgelegt ist, Zustandsdaten zu beschaffen, die einen Zustand einer Ausrüstung (10), die mit einem Steuerungsziel (20) versehen ist, angeben;
eine Betriebsgrößendatenbeschaffungseinheit (120), die ausgelegt ist, Betriebsgrößendaten zu beschaffen, die eine Betriebsgröße des Steuerungsziels (20) angeben;
eine Steuerungsmodellerzeugungseinheit (130), die ausgelegt ist, ein Steuerungsmodell (135), das die Betriebsgröße entsprechend dem Zustand der Ausrüstung (10) ausgibt, mittels Maschinenlernen unter Verwendung der Zustandsdaten und der Betriebsgrößendaten zu erzeugen;
eine Simulationseinheit (140), die ausgelegt ist, die Betriebsgröße, die von dem Steuerungsmodell (135) geliefert wird, in ein Simulationsmodell (145) einzugeben, um den Zustand der Ausrüstung (10) in einem Fall zu simulieren, in dem die Betriebsgröße, die durch das Steuerungsmodell (135) ausgegeben wird, dem Steuerungsziel (20) gegeben wird;
eine Bestimmungseinheit (150), die ausgelegt ist, auf der Grundlage eines Simulationsergebnisses, das von der Simulationseinheit (140) geliefert wird, zu bestimmen, ob die Steuerung des Steuerungsziels (20) durch das Steuerungsmodell (135) möglich ist;
**gekennzeichnet durch**
eine Befehlseinheit (160), die ausgelegt ist, dem Steuerungsziel (20) zu befehlen, die Steuerung durch die Betriebsgröße, die dem Steuerungsziel (20) von dem Steuerungsmodell (135) geliefert wird, zu starten, wenn bestimmt wird, dass die Steuerung des Steuerungsziels (20) durch das Steuerungsmodell (135) möglich ist, wobei
die Zustandsdaten Betriebsdaten, Verbrauchsdaten und Außenumgebungsdaten aufweisen, die von Sensoren, die für die Ausrüstung (10) vorgesehen sind, gemessen werden.

2. Bestimmungsvorrichtung (100) nach Anspruch 1, wobei
die Bestimmungseinheit (150) ausgelegt ist, zu bestimmen, dass die Steuerung des Steuerungsziels (20) durch das Steuerungsmodell (135) möglich ist, wenn auf der Grundlage des Simulationsergebnisses festgestellt wird, dass eine Zeitdauer, während der die Ausrüstung (10) normal betrieben werden kann, einen vorbestimmten Schwellenwert überschreitet.

3. Bestimmungsvorrichtung (100) nach Anspruch 1 oder 2, wobei
die Bestimmungseinheit (150) ausgelegt ist, zu bestimmen, dass die Steuerung des Steuerungsziels (20) durch das Steuerungsmodell (135) möglich ist, wenn auf der Grundlage des Simulationsergebnisses festgestellt wird, dass eine Anzahl von Malen, zu denen festgestellt wird, dass die Ausrüstung (10) normal betrieben werden kann, einen vorbestimmten Schwellenwert überschreitet.

4. Bestimmungsvorrichtung (100) nach einem der Ansprüche 1 bis 3, die außerdem eine Ausgabeeinheit aufweist, die ausgelegt ist, das Simulationsergebnis auszugeben, wobei
die Bestimmungseinheit (150) ausgelegt ist, zu bestimmen, dass die Steuerung des Steuerungsziels (20) durch das Steuerungsmodell (135) möglich ist, wenn ein Befehl zum Erlauben der Steuerung als Reaktion auf eine Ausgabe des Simulationsergebnisses beschafft wird.

5. Bestimmungsvorrichtung (100) nach einem der Ansprüche 1 bis 4, wobei
die Steuerungsmodellerzeugungseinheit (130) ausgelegt ist, das Steuerungsmodell (135) mittels Maschinenlernen erneut zu erzeugen, wenn bestimmt wird, dass die Steuerung des Steuerungsziels (20) durch das Steuerungsmodell (135) nicht möglich ist.

6. Bestimmungsvorrichtung (100) nach einem der Ansprüche 1 bis 5, die außerdem eine Konvergenzfeststellungseinheit aufweist, die ausgelegt ist, eine Konvergenz des Maschinenlernens festzustellen, wobei
die Simulationseinheit (140) ausgelegt ist, den Zustand der Ausrüstung (10) zu simulieren, wenn festgestellt wird, dass das Maschinenlernen konvergiert ist.

7. Bestimmungsvorrichtung (100) nach Anspruch 6, wobei
die Konvergenzfeststellungseinheit ausgelegt ist, die Konvergenz des Maschinenlernens auf der Grundlage einer seit dem Start des Maschinenlernens verstrichenen Zeit festzustellen.

8. Bestimmungsvorrichtung (100) nach Anspruch 6 oder 7, wobei
die Konvergenzfeststellungseinheit ausgelegt ist, die Konvergenz des Maschinenlernens auf der Grundlage eines Wertes einer Auswertungsfunktion des Maschinenlernens festzustellen.

9. Bestimmungsvorrichtung (100) nach einem der Ansprüche 1 bis 8, wobei
die Steuerungsmodellerzeugungseinheit (130) ausgelegt ist, als Reaktion auf eine Eingabe der Zustandsdaten das Steuerungsmodell (135) mittels Durchführung eines Verstärkungslernens derart zu erzeugen, dass eine Betriebsgröße, deren Belohnungswert, der durch eine vorbestimmte Belohnungsfunktion bestimmt wird, größer ist, als eine Empfehlungsbetriebsgröße ausgegeben wird.

10. Bestimmungsvorrichtung nach Anspruch 1, wobei
das Steuerungsziel (20) ausgelegt ist, zwischen einer Rückführungssteuerung durch eine zweite Betriebsgröße, die von einer Steuerung gegeben wird, und einer Künstliche-Intelligenz-Steuerung durch die Betriebsgröße, die von dem Steuerungsmodell (135) geliefert wird, zu wechseln, und
die Befehlseinheit (160) ausgelegt ist, dem Steuerungsziel (20) zu befehlen, von der Rückführungssteuerung durch die zweite Betriebsgröße zu der Künstliche-Intelligenz-Steuerung durch die Betriebsgröße, die von dem Steuerungsmodell (135) geliefert wird, zu wechseln, wenn bestimmt wird, dass die Steuerung des Steuerungsziels (20) durch das Steuerungsmodell (135) möglich ist.

11. Bestimmungsverfahren, das aufweist:
Beschaffen von Zustandsdaten, die einen Zustand einer Ausrüstung (10), die mit einem Steuerungsziel (20) versehen ist, angeben;
Beschaffen von Betriebsgrößendaten, die eine Betriebsgröße des Steuerungsziels (20) angeben;
Erzeugen eines Steuerungsmodells (135), das die Betriebsgröße entsprechend dem Zustand der Ausrüstung (10) ausgibt, mittels Maschinenlernen unter Verwendung der Zustandsdaten und der Betriebsgrößendaten;
Eingeben der Betriebsgröße, die von dem Steuerungsmodell (135) geliefert wird, in ein Simulationsmodell (145), um den Zustand der Ausrüstung (10) zu simulieren, in einem Fall, in dem die Betriebsgröße, die durch das Steuerungsmodell (135) ausgegeben wird, dem Steuerungsziel (20) gegeben wird;
Bestimmen, ob eine Steuerung des Steuerungsziels (20) durch das Steuerungsmodell (135) möglich ist, auf der Grundlage eines Simulationsergebnisses, das durch das Simulieren des Zustands der Ausrüstung (10) geliefert wird;
**gekennzeichnet durch**
dem Steuerungsziel (20) befehlen, die Steuerung durch die Betriebsgröße, die von dem Steuerungsmodell (135) an das Steuerungsziel (20) geliefert wird, zu starten, wenn bestimmt wird, dass die Steuerung des Steuerungsziels (20) durch das Steuerungsmodell (135) möglich ist, wobei
die Zustandsdaten Betriebsdaten, Verbrauchsdaten und Außenumgebungsdaten aufweisen, die von Sensoren, die für die Ausrüstung (10) vorgesehen sind, gemessen werden.

12. Bestimmungscomputerprogramm, das Befehle aufweist, die, wenn das Programm von einem Computer ausgeführt wird, bewirken, dass der Computer die Schritte des Verfahrens nach Anspruch 11 durchführt.

## Revendications

1. Appareil de détermination (100) comprenant :
une unité d'acquisition de données d'état (110) configurée pour acquérir des données d'état indiquant un état d'équipement (10) muni d'une cible de commande (20) ;
une unité d'acquisition de données de quantité d'opérations (120) configurée pour acquérir des données de quantité d'opérations indiquant la quantité d'opérations de la cible de commande (20) ; et
une unité de génération de modèle de commande (130) configurée pour générer un modèle de commande (135) qui délivre en sortie la quantité d'opérations correspondant à l'état de l'équipement (10), par un apprentissage automatique en utilisant les données d'état et les données de quantité d'opérations ;
une unité de simulation (140) configurée pour entrer la quantité d'opérations fournie par le modèle de commande (135) dans un modèle de simulation (145) pour simuler l'état de l'équipement (10) dans un cas où la quantité d'opérations délivrée en sortie par le modèle de commande (135) est donné à la cible de commande (20) ;
une unité de détermination (150) configurée pour déterminer si la commande de la cible de commande (20) par le modèle de commande (135) est possible, sur la base d'un résultat de simulation fourni par l'unité de simulation (140) ;
**caractérisé par**
une unité d'instruction (160) configurée pour ordonner à la cible de commande (20) de commencer la commande par la quantité d'opérations fournie par le modèle de commande (135) à la cible de commande (20) lorsqu'il est déterminé que la commande de la cible de commande (20) par le modèle de commande (135) est possible, dans lequel
les données d'état comprennent des données d'opération, des données de consommation et des données d'environnement externe mesurées par des capteurs équipant l'équipement (10).

2. Appareil de détermination (100) selon la revendication 1, dans lequel
l'unité de détermination (150) est configurée pour déterminer que la commande de la cible de commande (20) par le modèle de commande (135) est possible, lorsqu'il est estimé sur la base du résultat de simulation qu'une période pendant laquelle l'équipement (10) peut fonctionner normalement dépasse un seuil prédéterminé.

3. Appareil de détermination (100) selon la revendication 1 ou 2, dans lequel
l'unité de détermination (150) est configurée pour déterminer que la commande de la cible de commande (20) par le modèle de commande (135) est possible, lorsqu'il est estimé sur la base du résultat de simulation qu'un certain nombre de fois où il est estimé que l'équipement (10) peut fonctionner normalement dépasse un seuil prédéterminé.

4. Appareil de détermination (100) selon l'une quelconque des revendications 1 à 3, comprenant en outre une unité de sortie configurée pour délivrer en sortie le résultat de simulation, dans lequel
l'unité de détermination (150) est configurée pour déterminer que la commande de la cible de commande (20) par le modèle de commande (135) est possible lorsqu'une instruction pour permettre une commande est acquise à la suite d'une sortie du résultat de simulation.

5. Appareil de détermination (100) selon l'une quelconque des revendications 1 à 4, dans lequel
l'unité de génération de modèle de commande (130) est configurée pour régénérer le modèle de commande (135) par l'apprentissage automatique, lorsqu'il est déterminé que la commande de la cible de commande (20) par le modèle de commande (135) n'est pas possible.

6. Appareil de détermination (100) selon l'une quelconque des revendications 1 à 5, comprenant en outre une unité d'estimation de convergence configurée pour estimer la convergence de l'apprentissage automatique, dans lequel
l'unité de simulation (140) est configurée pour simuler l'état de l'équipement (10) lorsqu'il est estimé que l'apprentissage automatique a convergé.

7. Appareil de détermination (100) selon la revendication 6, dans lequel
l'unité d'estimation de convergence est configurée pour estimer la convergence de l'apprentissage automatique, sur la base d'un temps écoulé depuis le début de l'apprentissage automatique.

8. Appareil de détermination (100) selon la revendication 6 ou 7, dans lequel
l'unité d'estimation de convergence est configurée pour estimer la convergence de l'apprentissage automatique, sur la base d'une valeur d'une fonction d'évaluation de l'apprentissage automatique.

9. Appareil de détermination (100) selon l'une quelconque des revendications 1 à 8, dans lequel
l'unité de génération de modèle de commande (130) est configurée pour générer le modèle de commande (135), par réalisation d'un apprentissage par renforcement, de telle sorte qu'une quantité d'opérations dont une valeur de récompense déterminée par une fonction de récompense prédéterminée est plus élevée, soit délivrée en sortie en tant que quantité d'opérations recommandée, à la suite d'une entrée des données d'état.

10. Appareil de détermination selon la revendication 1, dans lequel
la cible de commande (20) est configurée pour commuter entre une commande de retour par une seconde quantité d'opérations donnée par un dispositif de commande et une commande d'intelligence artificielle par la quantité d'opérations fournie par le modèle de commande (135), et
l'unité d'instruction (160) est configurée pour ordonner à la cible de commande (20) de passer de la commande de retour par la seconde quantité d'opérations à la commande d'intelligence artificielle par la quantité d'opérations fournie par le modèle de commande (135) lorsqu'il est déterminé que la commande de la cible de commande (20) par le modèle de commande (135) est possible.

11. Procédé de détermination comprenant :
l'acquisition de données d'état indiquant un état d'un équipement (10) muni d'une cible de commande (20) ;
l'acquisition de données de quantité d'opérations indiquant une quantité d'opérations de la cible de commande (20) ;
la génération d'un modèle de commande (135), qui délivre en sortie la quantité d'opérations correspondant à l'état de l'équipement (10), par un apprentissage automatique en utilisant les données d'état et les données de quantité d'opérations ;
l'entrée de la quantité d'opérations fournie par le modèle de commande (135) dans un modèle de simulation (145) pour simuler l'état de l'équipement (10) dans un cas où la quantité d'opérations délivrée en sortie par le modèle de commande (135) est donnée à la cible de commande (20) ;
la détermination pour savoir si la commande de la cible de commande (20) par le modèle de commande (135) est possible, sur la base d'un résultat de simulation fourni par la simulation de l'état de l'équipement (10) ;
**caractérisé par**
l'ordre donné à la cible de commande (20) de commencer la commande par la quantité d'opérations fournie par le modèle de commande (135) à la cible de commande (20) lorsqu'il est déterminé que la commande de la cible de commande (20) par le modèle de commande (135) est possible, dans lequel
les données d'état comprennent des données d'opération, des données de consommation et des données d'environnement externe mesurées par des capteurs équipant l'équipement (10).

12. Programme informatique de détermination comprenant des instructions qui, lorsque le programme est exécuté par un ordinateur, amènent l'ordinateur à effectuer les étapes du procédé selon la revendication 11.
